# EUROPÄISCHE PATENTANMELDUNG

(11) **EP 3 955 463 A1**
(43) Veröffentlichungstag der Anmeldung: **16.02.2022**
(21) Anmeldenummer: 20190275.6
(22) Anmeldetag: 10.08.2020
(51) Int. Cl.: H03K 17/12, H03K 17/0814, H03K 17/08

(54) **PARALLELSCHALTUNG VON HALBLEITERSCHALTERN**

(71) Anmelder: Siemens Aktiengesellschaft, 80333 München (DE)
(72) Erfinder: Schierling, Hubert, 91052 Erlangen (DE)

(57) **Zusammenfassung**

Die Erfindung betrifft eine Halbleiteranordnung (1), aufweisend mindestens zwei Halbleiterschalter (2) und eine Ansteuerschaltung (3), wobei die mindestens zwei Halbleiterschalter (2) in einer Parallelschaltung angeordnet sind, wobei die Halbleiterschalter (2) jeweils einen Steueranschluss (21) aufweisen, wobei die Ansteuerschaltung (3) einen ersten Ausgang (31) aufweist, wobei der erste Ausgang (31) der Ansteuerschaltung (3) jeweils mit den Steueranschlüssen (21) der Halbleiterschalter (2) verbunden ist. Zur Verbesserung der Belastung der parallel angeordneten Halbleiterschalter (2) wird vorgeschlagen, dass in den Verbindungen (4) zwischen Ansteuerschaltung (3) und den jeweiligen Steueranschlüssen (21) jeweils ein temperaturabhängiges Element (5) angeordnet ist, wobei das temperaturabhängige Element (5) thermisch mit der Temperatur des betreffenden Halbleiterschalters (2) gekoppelt ist. Die Erfindung betrifft weiter einen Energiewandler (10), insbesondere einen Stromrichter (100) oder einen Gleichspannungssteller, mit mindestens einer derartigen Halbleiteranordnung (1). Ferner betrifft die Erfindung ein Verfahren zur gleichmäßigen Belastung einer derartigen Halbleiteranordnung (1) oder eines derartigen Energiewandlers (10), wobei eine durch die Belastung der Halbleiteranordnung (1) hervorgerufene Temperaturänderung durch das temperaturabhängige Element (5) erfasst wird, wobei mittels des temperaturabhängigen Elements (5) ein jeweiliges Ansteuersignal von der Ansteuerschaltung (3) an den Steueranschluss (21) des jeweiligen Halbleiterschalter (2) verändert wird.

## Beschreibung

Die Erfindung betrifft eine Halbleiteranordnung, aufweisend mindestens zwei Halbleiterschalter und eine Ansteuerschaltung, wobei die mindestens zwei Halbleiterschalter in einer Parallelschaltung angeordnet sind, wobei die Halbleiterschalter jeweils einen Steueranschluss aufweisen, wobei die Ansteuerschaltung einen ersten Ausgang aufweist, wobei der erste Ausgang der Ansteuerschaltung jeweils mit den Steueranschlüssen der Halbleiterschalter verbunden ist. Die Erfindung betrifft weiter einen Energiewandler, insbesondere einen Stromrichter oder einen Gleichspannungssteller, mit mindestens einer derartigen Halbleiteranordnung. Ferner betrifft die Erfindung ein Verfahren zur gleichmäßigen Belastung einer derartigen Halbleiteranordnung oder eines derartigen Energiewandlers.

Bei der Parallelschaltung von Halbleiterschaltern ist die symmetrische Stromaufteilung zwischen den Halbleiterschaltern nicht immer gewährleistet, auch wenn die betreffenden Halbleiterschalter von derselben Ansteuerschaltung angesteuert werden. Ursache können beispielsweise Unsymmetrien im Layout des Schaltungsträgers (z.B. DCB), wie beispielsweise unterschiedliche Streuinduktivitäten, im Emitter- und/oder Kollektorpfad oder in der Gateansteuerleitung, oder Streuungen in den Eigenschaften des Halbleiterschalters (beispielsweise der Threshold Spannung) sein. Die Unsymmetrie in der Stromaufteilung führt zu einer unterschiedlichen Belastung und damit zu einer unterschiedlichen Temperatur der Halbleiterschalter. Um die maximal zulässige Temperatur des am stärksten belasteten Halbleiterschalters nicht zu überschreiten, muss der Gesamtstrom der Parallelschaltung reduziert werden (Derating). Außerdem ergeben sich unterschiedliche Lebensdauern der parallel angeordneten Halbleiterschalter. Da die geringste Lebensdauer aller parallel angeordneten Halbleiterschalter bestimmend für die Lebensdauer der Parallelschaltung ist, reduziert sich die Lebensdauer der Parallelschaltung teilweise sogar erheblich durch die erhöhte Belastung aufgrund der Stromfehlverteilung.

Daher wird das Layout der Parallelschaltung der Halbleiterschalter möglichst symmetrisch ausgeführt. Die verbleibenden Unterschiede werden in Kauf genommen und durch ein Derating, d.h. einer Minderausnutzung der Chips der Halbleiterschalter, berücksichtigt.

Als Chip wird das Halbleitermaterial, meist Silizium, Siliziumkarbid oder Gallium-Nitrid, bezeichnet, das die Funktion des Schaltens, insbesondere des gesteuerten Schaltens, im Halbleiterschalter realisiert.

Als Leistungshalbleiter werden Halbleiter und Halbleiterschalter bezeichnet, die einen Strom von mehr als 1 A bei einer Spannung von mehr als 24 V schalten können. Nach oben geht die Leistungsfähigkeit von Leistungshalbleitern je nach Ausführungsart bis zu einigen Hundert Ampere und mehreren Tausend Volt pro Chip. Somit ergeben sich für ein gesamtes Leistungshalbleitermodul dann durch die Vielzahl der darin vorhandenen Chips eine Leistungsfähigkeit je nach Ausführungsart von bis zu mehreren Tausend Ampere und mehreren Tausend Volt.

Der Erfindung liegt die Aufgabe zugrunde, die Parallelschaltung von Halbleiterschaltern zu verbessern.

Diese Aufgabe wird durch eine Halbleiteranordnung, aufweisend mindestens zwei Halbleiterschalter und eine Ansteuerschaltung gelöst, wobei die mindestens zwei Halbleiterschalter in einer Parallelschaltung angeordnet sind, wobei die Halbleiterschalter jeweils einen Steueranschluss aufweisen, wobei die Ansteuerschaltung einen ersten Ausgang aufweist, wobei der erste Ausgang der Ansteuerschaltung jeweils mit den Steueranschlüssen der Halbleiterschalter verbunden ist, wobei in den Verbindungen zwischen Ansteuerschaltung und den jeweiligen Steueranschlüssen jeweils ein temperaturabhängiges Element angeordnet ist, wobei das temperaturabhängige Element thermisch mit der Temperatur des betreffenden Halbleiterschalters gekoppelt ist. Diese Aufgabe wird weiter durch einen Energiewandler, insbesondere einen Stromrichter oder einen Gleichspannungssteller, mit mindestens einer derartigen Halbleiteranordnung gelöst. Ferner wird die Aufgabe durch ein Verfahren zur gleichmäßigen Belastung einer derartigen Halbleiteranordnung oder eines derartigen Energiewandlers gelöst, wobei eine durch die Belastung der Halbleiteranordnung hervorgerufene Temperaturänderung durch das temperaturabhängige Element erfasst wird, wobei mittels des temperaturabhängigen Elements ein jeweiliges Ansteuersignal von der Ansteuerschaltung an den Steueranschluss des jeweiligen Halbleiterschalter verändert wird.

Weitere vorteilhafte Ausgestaltungen der Erfindung sind in den abhängigen Ansprüchen angegeben.

Der Erfindung liegt unter anderem die Erkenntnis zugrunde, dass die Temperatur der einzelnen Halbleiterschalter ein Maß für die Belastung des entsprechenden Halbleiterschalters ist. Die Temperatur ist in der Umgebung des Halbleiterschalters, insbesondere in der Umgebung des Chips des Halbleiterschalters oder am Chip des Halbleiterschalters erfassbar. Insbesondere kann daher auch die Temperatur des Chips des Halbleiterschalters durch das temperaturabhängige Element erfasst werden. Mit Erfassung der Temperatur ist gemeint, dass sich die elektrischen Eigenschaften des temperaturabhängigen Elements in Abhängigkeit von der Temperaturänderung an der Stelle des temperaturabhängigen Elements verändern. Mit anderen Worten geschieht die Erfassung der Temperatur dadurch, dass das thermische Element in Abhängigkeit der Temperatur elektrische Eigenschaften, wie beispielsweise einen bestimmten Widerstandswert, aufweist. Eine genauer Temperaturwert in einer bestimmten Einheit wie Kelvin oder Grad ist bei der Erfassung nicht erforderlich.

Somit ist die Temperaturdifferenz zweier parallel angeordneter Halbleiterschalter ein Maß für die Fehlverteilung des Stroms durch die Halbleiterschalter. Um der Fehlverteilung entgegenzuwirken ist das temperaturabhängige Element thermisch mit dem Halbleiterschalter gekoppelt, der über die Verbindung mit dem zuvor genannten temperaturabhängigen Element angesteuert wird. Mit anderen Worten ist das temperaturabhängige Element thermisch mit der Temperatur des betreffenden Halbleiterschalters gekoppelt. Mit betreffenden Halbleiterschalter ist der Halbleiterschalter gemeint, der über das genannte temperaturabhängige Element in der Verbindung zwischen Ansteuerschaltung und Steueranschluss des betreffenden Halbleiterschalters angesteuert wird. Damit wird die Ansteuerung der parallel angeordneten Halbleiterschalter verändert. Die Veränderung kann dabei beispielsweise durch eine zeitliche Verzögerung des Ansteuersignals und/oder eine Änderung der Spannungshöhe des Ansteuersignals realisiert werden.

Als temperaturabhängige Elemente können Bauteile zum Einsatz kommen, deren elektrisches Verhalten sich in Abhängigkeit von der Temperatur, insbesondere von der Umgebungstemperatur ändert. Die Temperatur, die zu einer Veränderung des elektrischen Verhaltens führt, wird auch als erfasste Temperatur bezeichnet. Beispiele für temperaturabhängige Elemente sind ein Widerstand, ein PTC Element, eine Diode, ein Transistor, ein Bonddraht oder eine Kombination aus zwei oder mehreren der genannten Komponenten.

Die Temperatur des Halbleiterschalters ergibt sich in erster Linie aus den Schaltverlusten und den Durchlassverlusten, die im Chip des Halbleiterschalters entstehen. Diese stellen die Belastung des Halbleiterschalters dar und bewirken den Temperaturunterschied in den Halbleiterschaltern, wenn diese eine ungleichmäßige Stromverteilung aufweisen. Durch die thermische Kopplung der Temperatur des Halbleiterschalters mit dem temperaturabhängigen Element wird das Ansteuersignal des betreffenden Halbleiterschalters verändert. Eine Erhöhung der Temperatur verringert über die Veränderung des Ansteuersignals den Stromfluss durch den betreffenden Halbleiterschalter. Somit wird die Belastung des Halbleiterschalters verringert. Je höher die Temperatur des Halbleiterschalters ist, desto stärker wird sein Chip durch die Veränderung des Ansteuersignals entlastet. Dies geschieht dadurch, dass das temperaturabhängige Element in der Verbindung zwischen Ansteuerschaltung und dem Steueranschluss des betreffenden Halbleiterschalters angeordnet ist. Das temperaturabhängige Element verändert sein elektrisches Verhalten in Abhängigkeit von der Temperatur. Es können damit das Schaltverhalten und/oder das Durchlassverhalten verändert werden. Sowohl das Schaltverhalten als auch das Durchlassverhalten sind in der Lage, die Stromaufteilung zwischen den parallel angeordneten Halbleiterschaltern derart zu beeinflussen, dass sich der Strom gleichmäßiger auf die parallel angeordneten Halbleiterschalter aufteilt.

Besonders vorteilhaft bei der vorgeschlagenen gleichmäßigen Belastung der parallelen Halbleiterschalter ist die einfache Realisierbarkeit. Für die Verbesserung der Stromaufteilung ist weiterhin nur lediglich genau ein Ausgangssignal, generiert von einer Ansteuerschaltung, für alle parallel angeordneten Halbleiterschalter erforderlich. Dies liegt am ersten Ausgang der Ansteuerschaltung an. Die Berücksichtigung und der Ausgleich der unterschiedlichen Belastung der geschalteten Halbleiterschalter findet mittels des temperaturabhängigen Elements in der Signalübertragung von Ansteuerschaltung zum jeweiligen Steueranschluss der parallelen Halbleiterschalter statt.

Da die bessere Stromaufteilung durch das temperaturabhängige Element in der Ansteuerleitung hardwaretechnisch vorgenommen wird, muss die Ansteuerschaltung nicht modifiziert werden. Somit kann auch bei bestehender Regelungs- oder Ansteuerumgebung durch die Halbleiteranordnung eine bessere Ausnutzung der Halbleiterschalter und der darin befindlichen Chips erreicht werden. Die Ansteuerschaltung benötigt weiterhin nur einen Ausgang für ein Ansteuersignal, das an die parallel angeordneten Halbleiterschalter übertragen wird.

Diese Anordnung bzw. das Verfahren eignet sich für alle Halbleiter, deren Schalt- und/oder Durchlassverhalten sich über den Steueranschluss beeinflussen lassen. Besonders vorteilhaft ist dies bei den Halbleitertypen IGBT, SiC-Mosfet und GaN-HEMT. Besonders vorteilhaft ist die Halbleiteranordnung bzw. das vorgeschlagene Verfahren für Leistungshalbleiter. Aufgrund der geschalteten Leistung wirkt sich eine ungleichmäßige Belastung entsprechend stark auf die Lebensdauer dieser Leistungshalbleiter aus. So sind diese Bauelemente besonders empfindlich gegenüber einer ungleichmäßigen Belastung. Anders ausgedrückt, ist durch eine gleichmäßige Belastung der parallel angeordneten Leistungshalbleiter, die Verlängerung der Lebensdauer besonders groß, wobei gleichzeitig die Gefahr des Ausfalls aufgrund von Überlastungen erheblich reduziert werden kann. Zudem eignet sich die Bauform des Moduls, in der die Leistungshalbleiter oftmals verfügbar sind, im Besonderen für den Aufbau der Halbleiterschaltung, da das temperaturabhängige Element im Modul gut anordenbar ist und die thermische Kopplung zum betreffenden Halbleiterschalter besonders gut ist.

Darüber hinaus ist das Verfahren und die Anordnung auf die Parallelschaltung von Halbleitermodulen übertragbar, wobei die einzelnen Halbleitermodule ihrerseits wieder eine vorgeschlagene Halbleiteranordnung aufweisen können.

Bei einer vorteilhaften Ausgestaltung der Erfindung unterscheidet sich die Länge der parallelen Strompfade zwischen den parallel angeordneten Halbleiterschaltern und/oder die Länge der Verbindungen zwischen Ansteuerschaltung und jeweiligem Steueranschluss, insbesondere um mehr als 20%. Aufgrund des Regelverhaltens der Anordnung mittels der temperaturabhängigen Elemente kann eine unterschiedliche Aufteilung der Ströme auf die Parallelschaltung durch unterschiedliche Leitungslängen und/oder Leitungsführung verringert werden. Diese sogenannte Fehlverteilung kommt unter anderem durch einen unsymmetrischen Schaltungsaufbau, d.h., ein unsymmetrisches Layout, zustande. Das unsymmetrische Layout kann sich aufgrund von unterschiedlichen Längen der Strompfade durch die parallel angeordneten Halbleiterschalter, durch unterschiedliche lange Verbindungen zwischen der Ansteuerschaltung und dem Steueranschluss oder parasitäre Effekte wie Streuinduktivitäten ergeben. Durch den vorgeschlagenen Aufbau der Halbleiteranordnung wird eine Fehlverteilung derart gut kompensiert, dass auch ein unsymmetrischer Aufbau der Parallelschaltung, insbesondere im Hinblick auf unterschiedliche lange Stromwege, möglich ist. So können für die Strompfade durch die unterschiedlichen parallelen Halbleiterschalter unterschiedliche Längen vorgesehen werden. Ebenso können die Ansteuerleitungen, also die Verbindungen zwischen Ansteuerschaltung und Steueranschluss des jeweiligen Halbleiterschalters eine unterschiedliche Länge aufweisen. Dies erhöht die Flexibilität bei der Anordnung der Parallelschaltung. Darüber hinaus ist auch die Wegführung flexibel, da auch Stromfehlverteilungen aufgrund unterschiedlicher parasitärer Induktivitäten in den Strompfaden zuverlässig ausgeglichen werden. Damit sind besonders kompakte Module, insbesondere Halbleitermodule, herstellbar, in deren Innern eine oder mehrere Parallelschaltungen von Halbleiterschaltern angeordnet sind.

Bei einer weiteren vorteilhaften Ausgestaltung der Erfindung wird das temperaturabhängige Element durch einen Widerstand, ein PTC Element, eine Diode, einen Transistor oder einen Bonddraht gebildet. Diese genannten temperaturabhängigen Elemente reagieren mit ihren elektrischen Eigenschaften derart gut auf Temperaturänderungen, dass sie sich im Besonderen für die Anwendung in der gleichmäßigen Aufteilungen der Belastung auf parallel angeordnete Halbleiterschalter eignen. Selbst geringe Fehlverteilungen und damit geringe Temperaturdifferenzen an den einzelnen temperaturabhängigen Elementen führen zu einer derart großen Änderung in ihren elektrischen Eigenschaften, dass eine zuverlässige Angleichung der Ströme durch die parallel angeordneten Halbleiterschalter erzielt werden kann. Zudem sind diese in hoher Stückzahl und preisgünstig am Markt verfügbar, da es sich um Standardkomponenten der Elektrik bzw. Elektronik handelt.

Bei einer weiteren vorteilhaften Ausgestaltung der Erfindung wird das temperaturabhängige Element durch eine Kombination von mindestens zwei Komponenten aus einem Widerstand, einem PTC Element, einer Diode, einem Transistor oder einem Bonddraht gebildet. Um das Regelverhalten beim Ausgleich unterschiedlich hoher Ströme zu beeinflussen, kann neben einzelnen Komponenten, die eine Abhängigkeit der elektrischen Eigenschaften von der Temperatur aufweisen auch eine Kombination mehrerer solcher Komponenten vorgenommen werden. Damit kann unter anderem eine besonders gleichmäßige oder eine besonders schnelle Gleichverteilung der Ströme erzielt werden.

Darüber hinaus ist es beispielsweise möglich, mit einem der genannten Komponenten das Einschaltverhalten und mit einer anderen Komponente das Ausschaltverhalten zu verändern. Damit kann durch die Kombination dieser beiden Komponenten die Gleichverteilung der Ströme optimiert werden.

Bei einer weiteren vorteilhaften Ausgestaltung der Erfindung ist das temperaturabhängige Element zumindest teilweise an einem Chip des Halbleiterschalters angeordnet. Der Chip des Halbleiterschalters ist meist die Quelle der Temperaturerhöhung, die es durch das temperaturabhängige Element zu erfassen gilt. Eine besonders schnelle und genaue Ausregelung von Stromfehlverteilungen kann dadurch erreicht werden, dass das temperaturabhängige Element an dem Chip des betreffenden Halbleiterschalters angeordnet ist. Dadurch kann besonders schnell auf sich ändernde Temperaturverhältnisse reagiert werden. Das temperaturabhängige Element kann dabei direkt oder ggf. über eine elektrisch isolierende und thermisch leitende Schicht an dem Chip befestigt werden.

Bereits heute existieren Chips zur Temperaturerfassung, sogenannte Temperaturerfassungschips, die an oder auf dem Chip des Halbleiters, zur Unterscheidung auch als Halbleiterchip bezeichnet, angebracht sind. Eine Möglichkeit, den Temperaturerfassungschip und den Halbleiterchip aneinander zu befestigen, besteht durch Kleben. Dadurch werden diese Chips zuverlässig und dauerhaft miteinander verbunden (Chip-on-Chip), indem sie aneinandergeklebt werden. Anstelle des Temperaturerfassungschips kann auch ein beliebiges temperaturabhängiges Element an den Halbleiterchip geklebt werden.

Bei einer weiteren vorteilhaften Ausgestaltung der Erfindung ist das temperaturabhängige Element zumindest teilweise an einem Gate-Pad angeordnet. Als Gate-Pad wird die Fläche auf dem Chip bezeichnet, auf die der Bonddraht des Ansteuersignals gebondet wird. Wenn man auf diese Fläche beispielsweise ein Widerstandsplättchen lötet oder, alternativ oder ergänzend, mit einem leitfähigen Kleber befestigt und darauf den Draht bondet, liegt der Widerstand direkt im Gatekreis. Eine elektrische und damit auch eine ansonsten unerwünschte thermische Isolation ist nicht erforderlich. Bei dieser Anordnung ist darüber hinaus keine Potenzialtrennung erforderlich. Die Anordnung kann somit potentialbehaftet ausgeführt sein. Somit kann auf einfache Weise das temperaturabhängige Element ohne weitere Komponenten zur Potenzialtrennung vorgesehen und angeordnet werden. Darüber hinaus ist die Platzierung derart nahe am Chip, dass eine Fehlverteilung über die Temperatur bzw. Temperaturdifferenz sich hinreichend schnell über das temperaturabhängige Element erfassen lässt bzw. über die temperaturabhängigen Elemente erfassen lassen.

Bei einer weiteren vorteilhaften Ausgestaltung der Erfindung ist das temperaturabhängige Element zumindest teilweise an einem Anschlusselement des Halbleiterschalters, insbesondere an einem Kollektoranschluss und/oder an einem Emitteranschluss des Halbleiterschalters, angeordnet. Das Anschlusselement wird oftmals auch als Kontaktierungselement bezeichnet. Meist, allerdings nicht notwendigerweise, ist das Element als Kupferelement ausgebildet. Das Kupferelement ist besonders gut thermisch leitend, so dass sich die Temperatur sowie auch Temperaturänderungen oder Temperaturdifferenzen gut und hinreichend schnell erfassen lassen.

Bei einer weiteren vorteilhaften Ausgestaltung der Erfindung ist das temperaturabhängige Element zwischen dem Steueranschluss und dem Gate-Pad als Bonddraht ausgebildet. Durch die Ausgestaltung als Bonddraht, lässt sich eine flexible und sichere Verbindung zwischen dem Steueranschluss und dem Gate-Pad herstellen, die sich insbesondere auch für eine Realisierung in einem Halbleitermodul eignet. Gleichzeitig ist der Bonddraht von seiner Lage und Beschaffenheit geeignet, auf die Temperaturerhöhung des Halbleiterschalters zu reagieren und damit einer Fehlverteilung der Stromaufteilung durch die parallel angeordneten Halbleiterschalter entgegenzuwirken.

Bei einer weiteren vorteilhaften Ausgestaltung der Erfindung sind die Halbleiterschalter und die temperaturabhängigen Elemente in einer baulichen Einheit, insbesondere in einem Halbleitermodul, angeordnet. Durch die erlaubten Unsymmetrien im Aufbau bzw. im Layout der Parallelschaltung, ist es möglich, eine Parallelschaltung von Halbleiterschaltern in ein Modul unterzubringen. Trotz des geringen vorhandenen Platzes kann mit den temperaturabhängigen Elementen eine Gleichverteilung der Ströme im Modul und damit auch eine gleichmäßige Belastung der parallel angeordneten Halbleiterschalter sichergestellt werden. Dies ist gerade auch für ein Modul wichtig, da sich die Lebensdauer des Moduls aus der geringsten Lebensdauer der eingesetzten Halbleiterschalter ergibt. Eine gleichmäßige Belastung der Halbleiterschalter erhöht dadurch signifikant die Lebensdauer eines derartig aufgebauten Moduls. Abschläge für eine Fehlverteilung können reduziert werden oder sogar komplett entfallen. Darüber hinaus ist auch das temperaturabhängige Element sicher im Modul untergebracht, so dass Störungen von außen, beispielsweise durch Schwankungen der Umgebungstemperaturen das Verhalten der Gleichaufteilung der Ströme nicht negativ beeinträchtigen. Nach außen kann ein derartiges Modul die gleichen Schnittstellen haben wie ein Modul ohne Maßnahmen zur gleichmäßigen Belastung der parallel angeordneten Halbleiterschalter. Somit ist ein derartiges Modul universell einsetzbar. Auch Anwendungen mit Modulen ohne Maßnahmen zur gleichmäßigen Belastung der parallel angeordneten Halbleiterschalter können durch das vorgeschlagene Modul ersetzt werden. Insbesondere ist es möglich, kleinere und/ oder kostengünstigere Module zu verwenden, da keine Überauslegung für eine Fehlverteilung vorzunehmen ist.

Zudem eignet sich die Bauform des Halbleitermoduls, in der die Halbleitschalter, insbesondere Leistungshalbleiter, oftmals verfügbar sind, im Besonderen für den Aufbau der Halbleiterschaltung, da das temperaturabhängige Element im Modul gut anordenbar ist und die thermische Kopplung zum betreffenden Halbleiterschalter besonders gut ist.

Bei einer weiteren vorteilhaften Ausgestaltung der Erfindung ist die Halbleiteranordnung und/oder ein eine derartige Halbleiteranordnung umfassender Energiewandler zum Betreiben einer elektrischen Maschine im Aussetzbetrieb, Kurzzeitbetrieb oder periodischem Betrieb eingerichtet. Dieser kurzzeitige Betrieb verursacht im Gegensatz zu einem Dauerbetrieb eine kurzzeitige aber recht hohe Belastung der einzelnen Halbleiterschalter. Eine entsprechende Fehlverteilung bei den parallel angeordneten Halbleiterschaltern sollte daher möglichst schnell ausgeregelt werden, um Ausfälle von Halbleiterschaltern oder eine signifikante Lebensdauerverkürzung zu vermeiden. Die vorgeschlagene Anordnung eignet sich im Besonderen durch die gute, zuverlässige und schnelle Erfassung auch zum schnellen Ausregeln von Stromfehlverteilungen. Daher haben Antriebe mit einer derartigen Halbleiterschaltung oder einem derartigen Energiewandler auch bei einem Kurzzeit-, Aussetz- oder periodischen Betrieb eine besonders hohe Lebensdauer und müssen nicht überdimensioniert werden.

Bei einer weiteren vorteilhaften Ausgestaltung der Erfindung ist die Halbleiteranordnung und/oder ein eine derartige Halbleiteranordnung umfassender Energiewandler eingerichtet zum Antreiben eines Fahrzeugs. Das zuvor genannte Anwendungsprofil von Kurzzeit-, Aussetz- oder periodischen Betrieb ist bei einem Fahrzeug vorhanden. Darüber hinaus ist der vorgeschlagene Aufbau der Halbleiteranordnung oder des Energiewandlers derart robust, dass er sich auch in einem Fahrzeug für hohe Zuverlässigkeit und Lebensdauer eignet.

Bei einer weiteren vorteilhaften Ausgestaltung der Erfindung ist die Veränderung als Zeitverzögerung derart ausgestaltet, dass bei gleicher Temperaturänderung des temperaturabhängigen Elementes ein Einschalten des Halbleiterschalters eine größere Zeitverzögerung aufweist als ein Ausschalten des Halbleiterschalters. Durch unterschiedliche Zeitverzögerungen beim Ein- und Ausschalten wird die Stromflussdauer beeinflusst. Dies ist eine besonders wirkungsvolle Methode, auf die Stromverteilung einzuwirken. Darüber wirkt es sich auch über die Ein- und Ausschaltverluste positiv auf eine gleichmäßige Belastung der Halbleiterschalter aus. Gerade bei geringen Temperaturunterschieden ist dieses Vorgehen besonders wirkungsvoll. Gegenüber einer Beeinflussung des Bahnwiderstands, beispielsweise mittels einer Veränderung der Spannungshöhe des Ansteuersignals, wirken sich die Zeitverzögerungen deutlich weniger auf die Verluste des Halbleiterschalters aus. Somit kann mit dieser Ausgestaltung des Verfahrens die Halbleiteranordnung besonders verlustarm, also mit hohem Wirkungsgrad, betrieben werden.

Bei einer weiteren vorteilhaften Ausgestaltung der Erfindung ist die Veränderung derart ausgestaltet, dass die Spannungshöhe des jeweiligen Ansteuersignals von der Temperatur des betreffenden Halbleiterschalters abhängt. Damit lässt sich der Bahnwiderstand des Chips, also die Eigenschaft im leitenden Zustand des Halbleiterschalters verändern. Eine Erhöhung des Durchlasswiderstands bringt Verluste und damit weitere Erwärmung und Belastung für den Halbleiterschalter mit sich. Diese Maßnahme eignet sich allerdings auch für die Feinjustierung der Aufteilung der Ströme auf die parallelen Halbleiterschalter. In geringem Maße angewandt sind die Auswirkungen auf die Verluste nur gering und fallen in der Gesamtbilanz nicht ins Gewicht. Darüber hinaus kann auch durch eine Erhöhung der Spannung, der Bahnverlust verringert werden. Insbesondere eine Abhängigkeit der Spannung des Ausgangssignals nicht nur von der Temperatur des betreffenden Halbleiterschalters sondern von allen parallel angeordneten Halbleiterschaltern erlaubt, den Durchlasswiderstand durch Erhöhung der Spannung absenken zu können und ermöglicht dadurch einen verlustarmen und wirtschaftlichen Betrieb einer derartigen Halbleiteranordnung.

Das vorgeschlagene Verfahren bzw. die vorgeschlagene Anordnung kann dadurch noch verbessert werden, dass mit steigender Temperatur der Halbleiteranordnung die Spannung des Ansteuersignals der Ansteuerschaltung erhöht wird. Mit anderen Worten kann die Spannung, insbesondere die Spannung des Ansteuersignals, am ersten Ausgang der Ansteuerschaltung in Abhängigkeit von der Temperatur der Halbleiteranordnung verändert werden. Die mittlere Temperatur kann von der Ansteuerschaltung selbst, beispielsweise durch Auswertung eines Temperatursensors, insbesondere durch die Auswertung eines Temperatursensors im Modul, oder durch eine überlagerte Steuereinheit, beispielsweise über ein thermisches Halbleitermodell, bestimmt und der Ansteuerschaltung zur Verfügung gestellt werden.

Im Folgenden wird die Erfindung anhand der in den Figuren dargestellten Ausführungsbeispiele näher beschrieben und erläutert. Es zeigen:
- FIG 1: eine Halbleiteranordnung mit parallel ange-ordneten Halbleiterschaltern aus dem Stand der Technik,
- FIG 2 bis FIG 6: vorgeschlagene Halbleiteranordnungen mit parallel angeordneten Halbleiterschaltern und jeweils einem temperaturabhängigen Element in den Ansteuerleitung,
- FIG 7: einen Stromrichter und
- FIG 8: ein Fahrzeug.

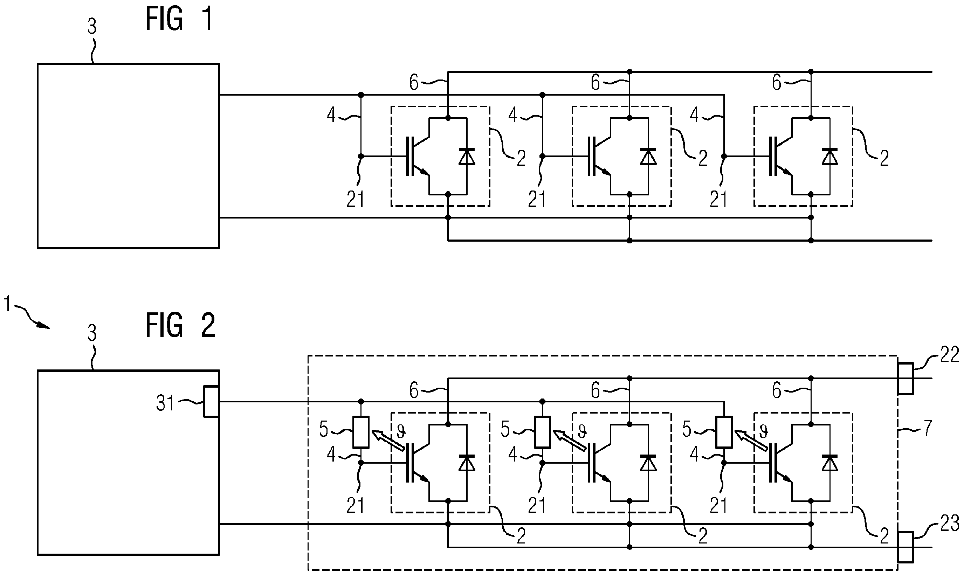

Die FIG 1 zeigt eine bekannte Halbleiteranordnung mit drei parallel angeordneten Halbleiterschaltern 2. Diese werden über ihre jeweiligen Steueranschlüsse 21 synchron von einer Ansteuerschaltung 3 angesteuert. Aufgrund von Unsymmetrien, beispielsweise aufgrund unterschiedlicher Länge der Verbindungen 4 zwischen Ansteuerschaltung 3 und den jeweiligen Steueranschlüssen 21 oder den unterschiedlich langen Strompfaden 6 zwischen den parallel angeordneten Halbleiterschaltern 2 ergibt sich eine ungleiche Verteilung der Ströme durch die parallel angeordneten Halbleiterschalter 2.

Die FIG 2 zeigt ein Ausführungsbeispiel für eine vorgeschlagene Halbleiteranordnung 1. Diese weist ebenfalls die parallel angeordneten Halbleiterschalter 2 auf, die von einer Ansteuerschaltung 3 angesteuert werden. Auch hier sind unterschiedlich lange Verbindungen 4 zwischen Ansteuerschaltung 3 und den jeweiligen Steueranschlüssen 21 sowie unterschiedlich lange Strompfade 6 zwischen den parallel angeordneten Halbleiterschaltern 2 vorhanden. Um jedoch eine ungleichmäßige Aufteilung des Stroms zu verhindern, ist in den Ansteuerleitung 4 zwischen der Ansteuerschaltung 3 und den jeweiligen Halbleiterschaltern 2 für jeden Halbleiterschalter 2 jeweils ein temperaturabhängiges Element 5 angeordnet. Die Anordnung erfolgt dabei so, dass jedes der temperaturabhängigen Elemente 5 genau auf einen Halbleiterschalter 2, der dann auch als betreffender Halbleiterschalter 2 bezeichnet werden kann, wirkt. Dabei ist das temperaturabhängige Element mit diesem betreffenden Halbleiterschalter 2 thermisch gekoppelt. In der FIG 2 wird dies durch den Pfeil mit der Beschriftung ϑ (für Temperatur) symbolisiert. Eine höhere Belastung des betreffenden Halbleiterschalters 2, insbesondere durch einen höheren Strom des betreffende Halbleiterschalters 2 im Vergleich zu den parallel angeordneten anderen Halbleiterschaltern 2, wird durch das temperaturabhängige Element 5 erkannt und wirkt sich auf die Ansteuerung, d.h. auf den Steueranschluss 21 des betreffenden Halbleiterschalters 2, aus. Diese Wirkung bzw. Rückwirkung wirkt dabei der erhöhten Belastung entgegen. Das kann beispielsweise durch eine verzögerte Schalthandlung oder ein verändertes Durchlassverhalten, wie einem erhöhten Bahnwiderstand des betreffenden Halbleiterschalters 2 im leitenden Zustand, geschehen. Das leitende Element 5 kann dabei beispielsweise durch einen Widerstand, ein PTC-Element oder einem Bonddraht gebildet werden. Für die Kompensation ist auch weiterhin nur ein erster Ausgang 31 der Ansteuerschaltung 3 erforderlich. Auch die Ansteuerschaltung 3 an sich muss gegenüber einer Anordnung ohne Ausgleich von unterschiedlicher Belastung der einzelnen Halbleiterschalter 2 nicht modifiziert werden.

Besonders vorteilhaft in dem Ausführungsbeispiel der FIG 2 ist die Ausgestaltung des temperaturabhängigen Elements 5 als Widerstand, auch als Gatewiderstand bezeichnet, da dieser Widerstand mit dem Gate, dem Steueranschluss 21, des Halbleiterschalters 2, verbunden ist. Der Gatewiderstand ist mit dem Halbleiterschalter 2, wie beschrieben, thermisch gekoppelt. Der Widerstandswert des Gatewiderstands steigt mit der Temperatur des Halbleiterschalters 2. Dadurch schaltet der Halbleiter langsamer ein als die parallel angeordneter Halbleiterschalter 2 und übernimmt dadurch weniger Strom. Die Einschaltverluste und die Leitverluste (Durchlassverluste) sinken. Das Verfahren ist insbesondere dann besonders wirkungsvoll, wenn beispielsweise die Einschalt- und Leitverluste höher sind als die Ausschaltverluste oder das Ausschalten durch die Ansteuerschaltung 3 so langsam erfolgt, dass der Widerstand als thermisches Element in der Verbindung 4 zwischen Ansteuerschaltung 3 und Steueranschluss 21 das Verhalten des Ausschaltvorgangs kaum noch beeinflusst.

Die parallel angeordneten Halbleiterschalter 2 und die temperaturabhängigen Elemente 5 können dabei vorteilhafterweise in einem Halbleitermodul 7 angeordnet werden. Das Halbleitermodul 7 bildet dann eine bauliche Einheit und wirkt an seinen Anschlüssen 21, 22, 23 wie ein einzelner Halbleiterschalter.

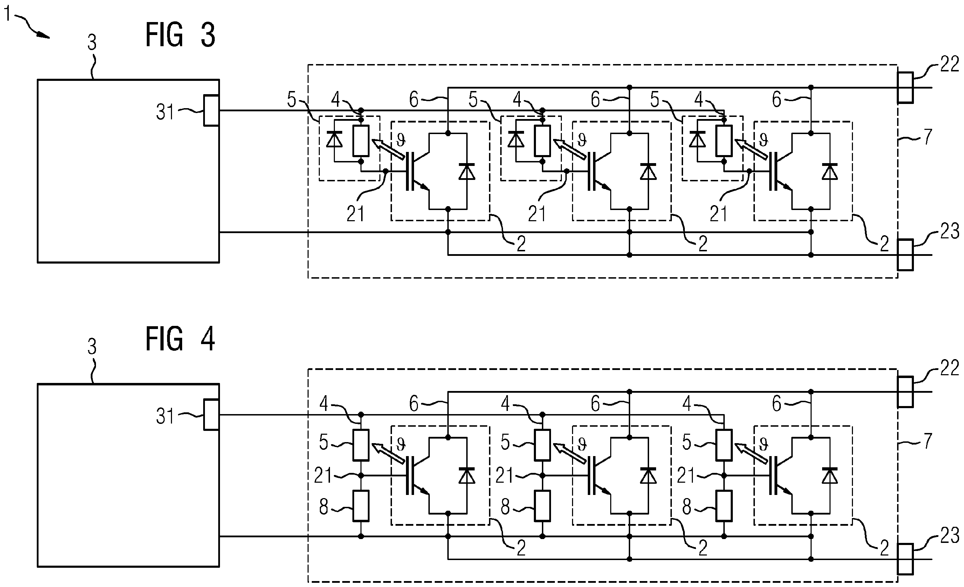

Die FIG 3 zeigt ein weiteres Ausführungsbeispiel einer vorgeschlagenen Halbleiteranordnung 1. Zur Vermeidung von Wiederholungen wird auf die Beschreibung zu den Figuren 1 und 2 sowie auf die dort eingeführten Bezugszeichen verwiesen. Im Vergleich zu dem Ausführungsbeispiel der FIG 2 wird beim vorliegenden Ausführungsbeispiel das temperaturabhängige Element 5 durch eine Kombination eines Widerstands mit einer Diode gebildet. Diese sind in einer Parallelschaltung angeordnet. Dabei wirkt der Widerstand in erster Linie zur Beeinflussung des Einschaltverhaltens, während die Diode in erster Linie das Ausschaltverhalten beeinflusst. Damit wird sichergestellt, dass man das Ein- und Ausschaltverhalten durch die Ansteuerschaltung 3 durch Verwendung einer Diode entkoppeln kann. Das Prinzip lässt sich dabei besonders vorteilhaft auf das vorgeschlagene Verfahren und/oder auf die vorgeschlagene Halbleiteranordnung 1 anwenden. Da das Ausschaltverhalten durch die Diode bestimmt wird, verschlechtert es sich nicht durch die Erhöhung des Widerstands. Die Diode hat dabei vorteilhafterweise eine geringere oder keine thermische Kopplung zum Halbleiterschalter. Da die Diode bei kleinen Strömen einen negativen Temperaturkoeffizienten hat, könnte man darüber hinaus auch das Ausschaltverhalten positiv beeinflussen, wenn man sie in diesem Bereich betreibt und thermisch gut koppelt.

Die FIG 4 zeigt ein weiteres Ausführungsbeispiel der vorgeschlagenen Halbleiteranordnung 1. Zur Vermeidung von Wiederholungen wird auf die Beschreibung zu den Figuren 1 bis 3 sowie auf die dort eingeführten Bezugszeichen verwiesen. Im Vergleich zu den Ausführungsbeispielen der Figuren 2 und 3 ist beim vorliegenden Ausführungsbeispiel das temperaturabhängige Element 5 Teil eines Spannungsteilers, der durch die Reihenschaltung des temperaturabhängigen Elementes 5 und einem weiteren Widerstand 8 gebildet wird und der die Spannung an dem Steueranschluss 21 beeinflusst. Dabei wird die Entlastung des betreffenden Halbleiterschalters 2 nicht nur über die Beeinflussung des Schaltverhaltens, sondern auch über das Leitverhalten vorgenommen. Durch die Anordnung entsteht ein temperaturabhängiger Spannungsteiler. Je höher die Temperatur ist, desto niedriger wird die Gatespannung, die Spannung am Steueranschluss 21. Damit erhöht sich der Durchlasswiderstand des betreffenden Halbleiterschalters 2 und der Anteil des Stroms betreffenden Halbleiterschalters am Gesamtstrom wird kleiner.

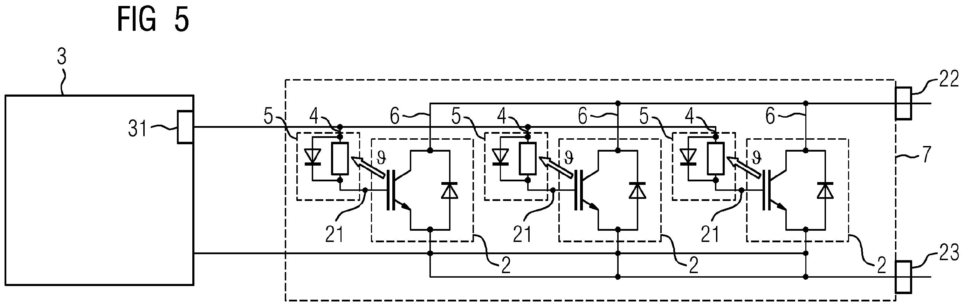

Die FIG 5 zeigt ein weiteres Ausführungsbeispiel mit zwei parallel angeordneten Halbleitermodulen 7. Zur Vermeidung von Wiederholungen wird auf die Beschreibung zu den Figuren 1 bis 4 sowie auf die dort eingeführten Bezugszeichen verwiesen. Dieses Ausführungsbeispiel weist eine hohe Ähnlichkeit mit dem Ausführungsbeispiel der FIG 3 auf, da als temperaturabhängiges Element 5 auch hier ein Widerstand und eine Diode in einer Parallelschaltung angeordnet sind. Diese Kombination von Diode und Widerstand wirkt aufgrund der gegenüber dem Ausführungsbeispiel der FIG 3 entgegengesetzten Polung der Diode jedoch unterschiedlich. Bei dem vorliegenden Ausführungsbeispiel wirkt die Diode und ihr Temperaturverhalten im Wesentlichen auf das Einschaltverhalten des Halbleiterschalters 2, während der parallel angeordnete Widerstand das Ausschaltverhalten beeinflusst. Optional kann in Reihe zur Diode auch noch ein zusätzlicher Widerstand eingefügt werden, der das Einschaltverhalten weiter optimiert. Dieser zusätzliche Widerstand kann dabei als temperaturabhängiger oder temperaturunabhängiger Widerstand ausgeführt sein. Ein temperaturabhängiger zusätzlicher Widerstand in Reihe zur Diode bringt beispielsweise den Vorteil, die temperaturabhängige Wirkung der Diode noch einmal zu verstärken und so die gleichmäßige Aufteilung des Stroms auf die parallel angeordneten Halbleiterschalter 2, insbesondere im Hinblick auf eine schnelle Ausregelung der Fehlverteilung, zu verbessern. Als vorteilhaft hat es sich auch bei dieser Anordnung erwiesen, dass sich eine Temperaturänderung unterschiedlich auf das Einschaltverhalten und Ausschaltverhalten des Halbleiterschalters 2 auswirkt. Dabei hat es sich als besonders vorteilhaft herausgestellt, wenn das Einschaltverhalten sich bei steigender Temperatur mehr verzögert als das Ausschaltverhalten.

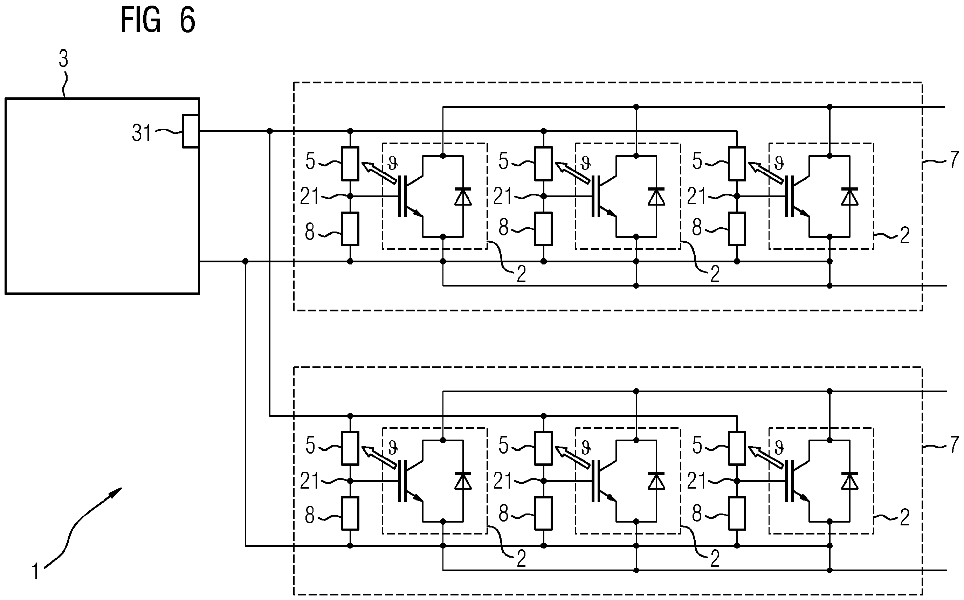

Die FIG 6 zeigt ein Ausführungsbeispiel mit zwei parallel angeordneten Halbleitermodulen 7. Zur Vermeidung von Wiederholungen wird auf die Beschreibung zu den Figuren 1 bis 5 sowie auf die dort eingeführten Bezugszeichen verwiesen. Für die Ansteuerung der Halbleiterschalter 2 wird auch von der Ansteuerschaltung 3 über einen ersten Ausgang 31 nur ein Ansteuersignal zur Ansteuerung der beiden parallel angeordneten Halbleitermodule 7 und damit aller parallel angeordneter Halbleiterschalter 2 bereitgestellt und an die Steueranschlüsse 21 übertragen. Die Parallelschaltung zweier oder mehr Halbleitermodule 7 ist auch dann möglich, wenn die Halbleitermodule 7 parallel angeordnete Halbleiterschalter 2 aufweisen. Somit lässt sich die vorgeschlagene Anordnung sowie das vorgeschlagene Verfahren auch auf die Parallelschaltung von Modulen oder auch auf andere Aufbautechniken übertragen.

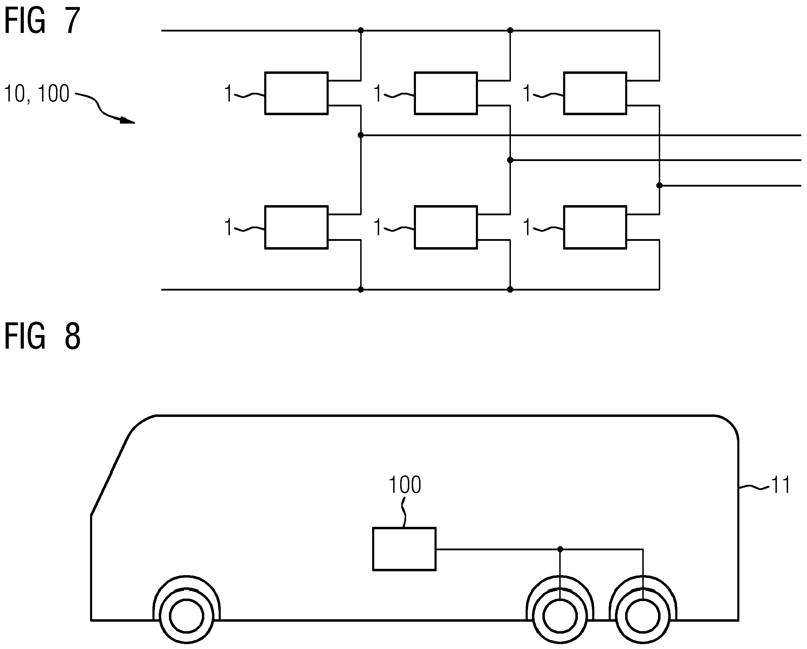

Die FIG 7 zeigt einen Stromrichter 100 als Beispiel für einen Energiewandler 10, der eine Vielzahl von Halbleiterschaltungen 1 zur Umwandlung der elektrischen Energie umfasst. Ebenso kann der Energiewandler 10 alternativ durch einen Gleichspannungssteller, auch als DC/DC Wandler bezeichnet, gebildet werden.

Die FIG 8 zeigt ein Fahrzeug mit einem derartigen Stromrichter 100 aus FIG 7, der ein Fahrzeug 11, in diesem Ausführungsbeispiel einen Bus antreibt.

Zusammenfassend betrifft die Erfindung eine Halbleiteranordnung, aufweisend mindestens zwei Halbleiterschalter und eine Ansteuerschaltung, wobei die mindestens zwei Halbleiterschalter in einer Parallelschaltung angeordnet sind, wobei die Halbleiterschalter jeweils einen Steueranschluss aufweisen, wobei die Ansteuerschaltung einen ersten Ausgang aufweist, wobei der erste Ausgang der Ansteuerschaltung jeweils mit den Steueranschlüssen der Halbleiterschalter verbunden ist. Zur Verbesserung der Belastung der parallel angeordneten Halbleiterschalter wird vorgeschlagen, dass in den Verbindungen zwischen Ansteuerschaltung und den jeweiligen Steueranschlüssen jeweils ein temperaturabhängiges Element angeordnet ist, wobei das temperaturabhängige Element thermisch mit der Temperatur des betreffenden Halbleiterschalters gekoppelt ist. Die Erfindung betrifft weiter einen Energiewandler, insbesondere einen Stromrichter oder einen Gleichspannungssteller, mit mindestens einer derartigen Halbleiteranordnung. Ferner betrifft die Erfindung ein Verfahren zur gleichmäßigen Belastung einer derartigen Halbleiteranordnung oder eines derartigen Energiewandlers, wobei eine durch die Belastung der Halbleiteranordnung hervorgerufene Temperaturänderung durch das temperaturabhängige Element erfasst wird, wobei mittels des temperaturabhängigen Elements ein jeweiliges Ansteuersignal von der Ansteuerschaltung an den Steueranschluss des jeweiligen Halbleiterschalter verändert wird.

## Patentansprüche

1. Halbleiteranordnung (1), aufweisend
- mindestens zwei Halbleiterschalter (2) und
- eine Ansteuerschaltung (3),
wobei die mindestens zwei Halbleiterschalter (2) in einer Parallelschaltung angeordnet sind, wobei die Halbleiterschalter (2) jeweils einen Steueranschluss (21) aufweisen, wobei die Ansteuerschaltung (3) einen ersten Ausgang (31) aufweist, wobei der erste Ausgang (31) der Ansteuerschaltung (3) jeweils mit den Steueranschlüssen (21) der Halbleiterschalter (2) verbunden ist, **dadurch gekennzeichnet, dass** in den Verbindungen (4) zwischen Ansteuerschaltung (3) und den jeweiligen Steueranschlüssen (21) jeweils ein temperaturabhängiges Element (5) angeordnet ist, wobei das temperaturabhängige Element (5) thermisch mit der Temperatur des betreffenden Halbleiterschalters (2) gekoppelt ist.

2. Halbleiteranordnung (1) nach Anspruch 1, wobei sich die Länge der parallelen Strompfade (6) zwischen den parallel angeordneten Halbleiterschaltern (2) und/oder die Länge der Verbindungen (4) zwischen Ansteuerschaltung (3) und jeweiligem Steueranschluss (21) unterscheiden, insbesondere sich um mehr als 20% unterscheiden.

3. Halbleiteranordnung (1) nach einem der Ansprüche 1 oder 2, wobei das temperaturabhängige Element (5) durch einen Widerstand, ein PTC Element, eine Diode, einen Transistor oder einen Bonddraht gebildet wird.

4. Halbleiteranordnung (1) nach einem der Ansprüche 1 bis 3, wobei das temperaturabhängige Element (5) durch eine Kombination von mindestens zwei Komponenten aus einem Widerstand, einem PTC Element, einer Diode, einem Transistor oder einem Bonddraht gebildet wird.

5. Halbleiteranordnung (1) nach einem der Ansprüche 1 bis 4, wobei das temperaturabhängige Element (5) zumindest teilweise an einem Chip des Halbleiterschalters angeordnet ist.

6. Halbleiteranordnung (1) nach einem der Ansprüche 1 bis 5, wobei das temperaturabhängige Element (5) zumindest teilweise an einem Gate-Pad angeordnet ist.

7. Halbleiteranordnung (1) nach einem der Ansprüche 1 bis 6, wobei das temperaturabhängige Element (5) zumindest teilweise an einem Anschlusselement des Halbleiterschalters (2), insbesondere an einem Kollektoranschluss (22) und/oder an einem Emitteranschluss (23) des Halbleiterschalters (2) angeordnet ist.

8. Halbleiteranordnung (1) nach einem der Ansprüche 1 bis 7, wobei das temperaturabhängige Element (5) zwischen dem Steueranschluss (21) und dem Gate-Pad als Bonddraht ausgebildet ist.

9. Halbleiteranordnung (1) nach einem der Ansprüche 1 bis 8, wobei die Halbleiterschalter (2) und die temperaturabhängigen Elemente (5) in einer baulichen Einheit, insbesondere in einem Halbleitermodul (7), angeordnet sind.

10. Energiewandler (10), insbesondere ein Stromrichter (100) oder ein Gleichspannungssteller, mit mindestens einer Halbleiteranordnung (1) nach einem der Ansprüche 1 bis 9.

11. Energiewandler (10) nach Anspruch 10, eingerichtet zum Betreiben einer elektrischen Maschine im Aussetzbetrieb, Kurzzeitbetrieb oder periodischem Betrieb.

12. Energiewandler (10) nach einem der Ansprüche 10 oder 11, eingerichtet zum Antreiben eines Fahrzeugs (11).

13. Verfahren zur gleichmäßigen Belastung einer Halbleiteranordnung (1) nach einem der Ansprüche 1 bis 9 oder eines Energiewandlers (10) nach einem der Ansprüche 10 bis 12, wobei eine durch die Belastung der Halbleiteranordnung (1) hervorgerufene Temperaturänderung durch das temperaturabhängige Element (5) erfasst wird, wobei mittels des temperaturabhängigen Elements (5) ein jeweiliges Ansteuersignal von der Ansteuerschaltung (3) an den Steueranschluss (21) des jeweiligen Halbleiterschalter (2) verändert wird.

14. Verfahren nach Anspruch 13, wobei die Veränderung als Zeitverzögerung derart ausgestaltet ist, dass bei gleicher Temperaturänderung des temperaturabhängigen Elementes (5) ein Einschalten des Halbleiterschalters (2) eine größere Zeitverzögerung aufweist als ein Ausschalten des Halbleiterschalters (2) .

15. Verfahren nach einem der Ansprüche 13 oder 14, wobei die Veränderung derart ausgestaltet ist, dass die Spannungshöhe des jeweiligen Ansteuersignals von der Temperatur des betreffenden Halbleiterschalters (2) abhängt.
